# EUROPÄISCHE PATENTANMELDUNG

(11) **EP 2 284 889 A1**
(43) Veröffentlichungstag der Anmeldung: **16.02.2011**
(21) Anmeldenummer: 10006520.0
(22) Anmeldetag: 23.06.2010
(51) Int. Cl.: H01L 25/07, H01L 23/48

(54) **Leistungshalbleitermodul mit Schaltungsträger und Lastanschlusselement sowie Herstellungsverfahren hierzu**

(30) Priorität: 12.08.2009 DE 102009037257
(71) Anmelder: Semikron Elektronik GmbH & Co. KG Patentabteilung, 90431 Nürnberg (DE)
(72) Erfinder: Bogen, Ingo, 90403 Nürnberg (DE); do Nascimento-Singer, Jair, 91077 Dormitz (DE); Walter, Alexej, 90431 Nürnberg (DE)

(57) **Zusammenfassung**

Die Erfindung zeigt ein Leistungshalbleitermodul und ein Verfahren zu dessen Herstellung. Hierzu ist es notwendig einen Schaltungsträger mit einer hierauf ausgebildeten leistungselektronischen Schaltungsanordnung bereitzustellen, der in einer zugeordneten Ausnehmung eines Kunststoffformteils angeordnet wird. Mindestens eine Verbindungseinrichtung zu externen elektrischen Verbindung wird in einer zweiten Ausnehmung des Kunststoffformkörpers angeordnet. Anschließend werden Lastanschlusselemente zu dem Kunststoffformkörper derart angeordnet, dass hierbei die erste Kontakteinrichtung der Lastanschlusselemente auf einem ersten Widerlager des Kunststoffformkörpers zu liegen kommt und die zweiten Kontakteinrichtungen auf ihren Kontaktpartnern der leistungselektronischen Schaltungsanordnung zu liegen kommen. Anschließend werden schaltungsgerechte stoffschlüssige Verbindung der zweiten Kontakteinrichtungen mit den Kontaktpartnern der leistungselektronischen Schaltungsanordnung sowie ein Gehäuse angeordnet.

## Beschreibung

Die Erfindung beschreibt die Herstellung und ein zugehöriges Leistungshalbleitermodul mit einem Gehäuse und einem Schaltungsträger, bestehend aus einem Substrat welches Leiterbahnen zur Anordnung und schaltungsgerechten Verbindung von Leistungshalbleiterbauelementen bereitstellt und somit die leistungselektronische Schaltungsanordnung ausbildet. Es sind ebenso Schaltungsträger bekannt die zusätzlich eine metallische Grundplatte zur Anordnung des Substrats aufweisen. Von diesem Schaltungsträger reichen, ausgehend von den Leiterbahnen und / oder den Leistungshalbleiterbauelementen, Lastanschlusselemente zu ihnen zugeordneten ersten Kontakteinrichtungen zur externen Kontaktierung des Leistungshalbleitermoduls.

Beispielhaft ist in der DE 101 00 460 A1 ein Leistungshalbleitermodul der genannten Art offenbart, wie es in seiner Grundausprägung seit langem bekannt ist. Derartige Leistungshalbleitermodule gemäß dem Stand der Technik weisen einen Substratträger auf, der den unteren Abschluss des Leistungshalbleitermoduls bildet. Das Isolierstoffgehäuse überragt hierbei diesen Substratträger an seinen Längsseiten geringfügig um ihn zu umschließen. Der hier offenbarte Substratträger weist eine flächige Grundplatte, vorzugsweise aus Kupfer auf, die der Wärmespreizung und dem Wärmetransport von der leistungselektronischen Schaltungsanordnung zu einem anordenbaren Kühlbauteil dienen.

Allgemein aus dem Stand der Technik ist bekannt, dass der Substratträger mit dem Gehäuse verklebt ist, um bei einer Befüllung des Gehäuses, mit einem zu diesem Zeitpunkt gelartigen Silikonkautschuk zur inneren Isolierung, ein Ausfließen zu verhindern. Bei der Herstellung derartiger Leistungshalbleitermodule werden die Klebeverbindungen in einem Dispensverfahren mit anschließender Trocknungsphase des Klebstoffes erzeugt.

Weiterhin ist das Gehäuse meist mittels metallischer Nietverbindungen mit dem Substratträger verbunden. Diese Nietverbindungen sind als Hohlkörper mit einer durchgehenden Aussparung ausgebildet um ebenso eine Befestigung des Leistungshalbleitermoduls auf einem Kühlbauteil mittels einer Schraubverbindung zu ermöglichen.

Weiterhin dem Stand der Technik zuzuordnen sind verschieden ausgestaltete Anschlusselemente der Last- und auch der Hilfsanschlusselemente. Hierbei sind verschiedene Verbindungstechnologien dieser Anschlusselemente mit den Leiterbahnen des Substrats oder den Leistungshalbleiterbauelementen der Schaltungsanordnung bekannt. Besonders bevorzugt und seit langem bekannt sind hierbei stoffschlüssige Verbindungen, meist als Löt-, aber auch als Schweiß- oder Drucksinterverbindungen ausgebildet.

Zur externen Kontaktierung weisen vorzugsweise die Lastanschlusselemente eine Verbindungseinrichtung zur Schraubverbindung auf. Diese sind häufig ausgebildet mit einer in das Gehäuse lose eingebettete Schraubenmuttern mit Innengewinde und hierüber angeordnetem Abschnitte des Lastanschlusselements mit einer zum Innengewinde der Schraubenmutter hin fluchtenden durchgehenden Aussparung. Bei der bekannten Herstellung derartiger Leistungshalbleitermodule werden diese Schraubenmuttern als einer der letzten Arbeitsgänge in die Aussparungen des fast fertig gestellten Leistungshalbleitermoduls eingelegt. Die Sicherung gegen Herausfallen wird dann durch Abkanten der Kontakteinrichtung des Lastanschlusselements bewirkt.

Der Erfindung liegt die Aufgabe zugrunde, ein Leistungshalbleitermodul und ein Herstellungsverfahren hierfür anzugeben das einem kostengünstigen und automatisierbaren Prozessablauf zugänglich ist.

Diese Aufgabe wird erfindungsgemäß gelöst, durch ein Leistungshalbleitermodul mit den Merkmalen des Anspruchs 1 und durch ein Herstellungsverfahren mit den Merkmalen des Anspruchs 7. Bevorzugte Ausführungsformen sind in den jeweils abhängigen Ansprüchen beschrieben.

Den Ausgangspunkt der Erfindung bildet ein Leistungshalbleitermodul vorgesehen zur Anordnung auf einem externen Kühlbauteil zur Abführung der im Leistungshalbleitermodul entstandenen Wärme. Dieses Leistungshalbleitermodul weist ein Gehäuse, meist aus einem elektrisch isolierenden Kunststoffmaterial, mindestens einen Schaltungsträger, mindestens ein Lastanschlusselement und einen Kunststoffformkörper auf. Dieser Kunststoffformkörper umschließt den Schaltungsträger und ist selbst teilweise von dem Gehäuse umschlossen.

Der Schaltungsträger ist gemäß dem Stand der Technik ausgebildet und weist eine leistungselektronische Schaltungsanordnung auf. Von dieser geht das mindestens eine Lastanschlusselement aus und dient der externen Kontaktierung des Leistungshalbleitermoduls. Das mindestens eine Lastanschlusselement weist hierzu eine erste Kontakteinrichtung mit einer ersten Aussparung auf. Im weiteren Verlauf weist es einen bandartigen Abschnitt und mindestens zwei zweite Kontakteinrichtungen auf. Diese zweiten Kontakteinrichtungen sind elektrisch leitend mit der leistungselektronischen Schaltungsanordnung verbunden.

Die ersten Kontakteinrichtungen des mindestens einen Lastanschlusselements sind auf einer Fläche des Kunststoffformkörpers angeordnet, die als erstes Widerlager dient und eine zweite Aussparung aufweist, in der eine Verbindungseinrichtung, vorzugsweise eine Schraubenmutter, angeordnet ist. Diese zweite Aussparung des Kunststoffformkörpers fluchtet mit der ersten Aussparung der ersten Kontakteinrichtung des Lastanschlusselements um zur externen elektrischen Kontaktierung eine Schraubverbindung mit der Schraubenmutter ausbilden zu können.

Das erfindungsgemäße Verfahren zur Herstellung eines Leistungshalbleitermoduls ausgebildet gemäß obiger Ausgestaltung ist gekennzeichnet durch folgende wesentliche Schritte:
- Bereitstellen mindestens eines Schaltungsträgers mit einer hierauf ausgebildeten leistungselektronischen Schaltungsanordnung.
- Anordnen des jeweiligen Schaltungsträgers in einer zugeordneten Ausnehmung des Kunststoffformteils, wobei diese ein zweites Widerlager aufweist, zur Begrenzung der Bewegung des Schaltungsträgers in Richtung des Innenraums des Leistungshalbleitermoduls. Hierbei ist es bevorzugt, wenn zwischen dem Innenrand der Ausnehmung und dem Schaltungsträger eine dauerelastische Dichteinrichtung (20) angeordnet. Bei dieser Ausgestaltung wird der jeweilige Schaltungsträger in die zugeordnete Ausnehmung gepresst, wodurch die Dichtung an dessen Außenrand anliegt und den Innenraum des Leistungshalbleitermoduls nach unten abdichtet. Somit kann auf eine Klebeverbindung, mit all ihren bekannten Nachteilen, als Abdichtung des Innenraums des Leistungshalbleitermoduls verzichtet werden.
- Anordnen der Verbindungseinrichtung in der zweiten Ausnehmung des Kunststoffformkörpers.
- Anordnen des mindestens einen Lastanschlusselements zu dem Kunststoffformkörper, wobei die erste Kontakteinrichtung auf ihrem ersten Widerlager zu liegen kommt und wobei die zweiten Kontakteinrichtungen auf ihren Kontaktpartnern der leistungselektronischen Schaltungsanordnung zu liegen kommen. Es ist besonders bevorzugt, wenn der bandartige Abschnitt zu mehr als 80% seines Verlaufs von den zweiten Kontakteinrichtung zu ersten Kontakteinrichtung geschlitzt ausgebildet ist. Durch diese Ausgestaltung wird die parasitäre Induktivität des Lastanschlusselements um mindestens 20% verringert gegenüber eine Ausgestaltung mit einer Länge des Schlitzes von nur 30% des Verlaufs des bandartigen Abschnitts. Weiterhin kann es bevorzugt sein gleichzeitig mit den Lastanschlusselementen auch Hilfsanschlusselemente mit eigenen weiteren Kontakteinrichtungen zu dem Kunststoffformkörper anzuordnen.
- Ausbilden, vorzugsweise mittels eines Schweißverfahrens, der schaltungsgerechten stoffschlüssigen Verbindung der zweiten Kontakteinrichtungen der Lastanschlusselemente mit den Kontaktpartnern der leistungselektronischen Schaltungsanordnung. Diese Kontaktpartner sind vorzugsweise Leiterbahnen eines Substrats. Es kann allerdings auch vorteilhaft sein, als Kontaktpartner die Leistungshalbleiterbauelement und dort selbstverständlich deren Kontaktflächen auszuwählen. Vorteilhaft ist es ebenso die weiteren Kontakteinrichtungen der Hilfsanschlusselemente in diesem Arbeitsschritt mit ihren Verbindungspartnern und mit gleicher Verbindungstechnologie zu verbinden. Durch die Ausgestaltung des Kunststoffformkörpers mit dem ersten Widerlager zur Auflage der ersten Kontakteinrichtung und die Anordnung des mindestens einen Schaltungsträgers in einer Ausnehmung mit einem zweiten Widerlager ergibt sich nach der stoffschlüssigen Verbindung der zweiten Kontakteinrichtungen ein Verbund aus Kunststoffformkörper, Schaltungsträger und Lastanschlusselement der eine Einheit ausbildet bei der alle Komponenten ohne zusätzliche Verbindungsmittel, wie beispielhaft Klebe- oder Nietverbindungen zueinander fixiert sind.
- Anordnen des Gehäuses, wobei vorteilhafterweise der Kunststoffformkörper vorteilhafterweise fast vollständig umschlossen wird. Hierbei bleiben die ersten Kontakteinrichtungen selbstverständlich von außen zugänglich um die elektrische Kontaktierung des Leistungshalbleitermoduls zu ermöglichen.

Vorteilhaft an dem genannten Herstellungsverfahren und dem zugeordnete Leistungshalbleitermodul ist, dass es einem Herstellungsprozess aus Teilmodulen, wie dem Schaltungsträger, dem Kunststoffformkörper, den Verbindungseinrichtungen, den Anschlusselementen, insbesondere den Lastanschlusselementen, und dem Gehäuse gefertigt werden kann, wodurch eine wirtschaftliche und automatisierbare Herstellung ermöglicht wird.

Besonders bevorzugte Weiterbildungen der Erfindung sind in der jeweiligen Beschreibung der Ausführungsbeispiele genannt. Die erfinderische Lösung wird zudem an Hand der Ausführungsbeispiele und der Fig. 1 bis 3 weiter erläutert.

Fig. 1 zeigt eine Explosionszeichnung eines erfindungsgemäßen Leistungshalbleitermoduls.

Fig. 2 zeigt in einer Explosionszeichnung zwei Herstellungsschritte im Rahmen des erfindungsgemäßen Herstellungsverfahrens eines erfindungsgemäßen Leistungshalbleitermoduls.

Fig. 3 zeigt einen Kunststoffformkörper eines erfindungsgemäßen Leistungshalbleitermoduls.

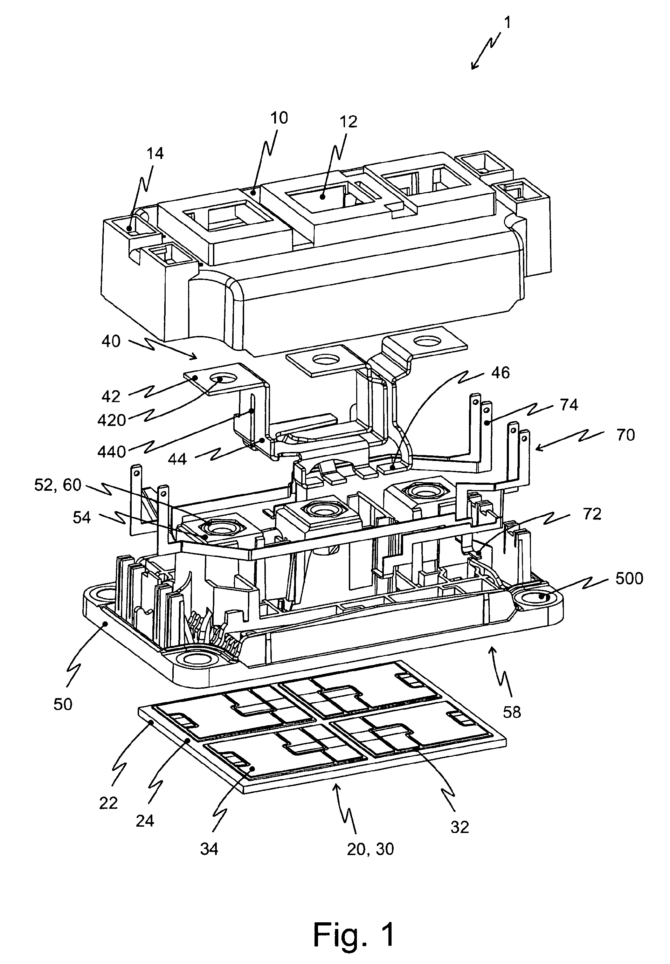

Fig. 1 zeigt eine Explosionszeichnung eines erfindungsgemäßen Leistungshalbleitermoduls (1). Dargestellt ist ein Schaltungsträger (20), hier bestehend aus einer Grundplatte (24) und vier hierauf angeordneten Substraten (32). Die Verbindung der Grundplatte (24) mit diesen Substraten (32) ist als Löt- oder Drucksinterverbindung ausgebildet. Die Substrate (32) weisen eine Mehrzahl von gegeneinander und gegen die Grundplatte (24) isolierte Leiterbahnen (34) auf. Auf diesen Leiterbahn (34) und schaltungsgerecht mit weiteren verbunden sind, allerdings nicht dargestellt, Leistungshalbleiterbauelemente angeordnet, wodurch die leistungselektronische Schaltungsanordnung (30) hier in Form eine H- Brückenschaltung ausgebildet wird. Derartige Schaltungsträger (20) sind vielfach aus dem Stand der Technik bekannt.

Weiterhin dargestellt ist der Kunststoffformkörper (50), der hier an seinen Ecken jeweils eine weitere Ausnehmung (500) zur Verbindung mit einem externen Kühlbauteil aufweist. Zudem weist der Kunststoffformkörper (50) drei zweite Ausnehmungen (52) zur Anordnung von Schraubenmuttern (60) auf, die nach Fertigstellung des Leistungshalbleitermoduls (1) der externen Kontaktierung der Lastanschlusselemente (40) dienen.

Die Lastanschlusselemente (40) selbst weisen jeweils eine erste Kontakteinrichtung (42) mit einer ersten Ausnehmung (420) zur Durchführung einer Schraubverbindung, eine sich hieran anschließenden bandartigen Abschnitt (44) und zwei oder vier zweite Kontakteinrichtungen (46) auf. Der bandartige Abschnitt (44) ist zur Verringerung der parasitären Induktivitäten des jeweiligen Lastanschlusselements (40) in seinem Verlauf von den zweiten Kontakteinrichtungen (46) her geschlitzt (440) ausgebildet, wodurch die Strompfade von der ersten (42) zu den zweiten Kontakteinrichtungen (46) im wesentlichen Verlauf voneinander getrennt sind.

Die zweiten Kontakteinrichtungen (46) sind als Kontaktfüße mit einem flächigen Bereich parallel zu den Substraten (32) ausgeführt, wodurch die Ausbildung der stoffschlüssigen Verbindung, die vorteilhafterweise eine Schweißverbindung ist, zu den Leiterbahnen (34) des Substrats (32) vereinfacht wird.

Die Hilfsanschlusselemente (70) sind in Führungen des Kunststoffformkörper (50) angeordnet und weisen zur Verbindung mit den schaltungsgerecht zugeordneten Leiterbahnen (34) der Substrate (32) gleichartig zu den zweiten Kontakteinrichtungen (46) der Lastanschlusselemente (40) ausgebildete weitere Kontakteinrichtungen (72) auf, zur externen Verbindung sind diese als Steckkontakte (74) ausgebildet.

Das Gehäuse (10) des Leistungshalbleitermoduls (1) umschließt den Kunststoffformkörper (50) allseits, reicht hierbei allerdings nicht bis auf die Ebene des Schaltungsträgers (20) hinab. Zudem spart (12, 14) das Gehäuse (10) die ersten Kontakteinrichtungen (42) der Lastanschlusselemente (40) wie auch die Kontakteinrichtungen (72) der Hilfsanschlusselemente (70) zur externen elektrischen Verbindung frei.

Die einzelnen Komponenten dieser Explosionszeichnung verdeutlichen gleichzeitig auch die einzelnen erfindungsgemäßen Herstellungsschritte. Nach dem Bereitstellen des Schaltungsträgers (20) wird der Kunststoffformkörper (50) hier bereits mit Schraubenmuttern (60) versehen zu dem Schaltungsträger (20) angeordnet. In einem nächsten Schritt werden die Last- (40) und auch Hilfsanschlusselemente (70) angeordnet, wozu der Kunststoffformkörper (50) eine Mehrzahl von Führungselementen aufweist. Wesentlich ist hier, dass die ersten Kontakteinrichtungen (42) auf Widerlagern (54) des Kunststoffformkörper (50) zu liegen kommen und bei der Verbindung der zweiten Kontakteinrichtungen (46) mit Leiterbahnen (34) der Substrate (32) alle bisher genannten Komponenten ohne weiter Verbindungsmittel zueinander fixiert werden, was für die Handhabung im Rahmen einer Automatisierung der Herstellung einen wesentlichen Vorteil bietet.

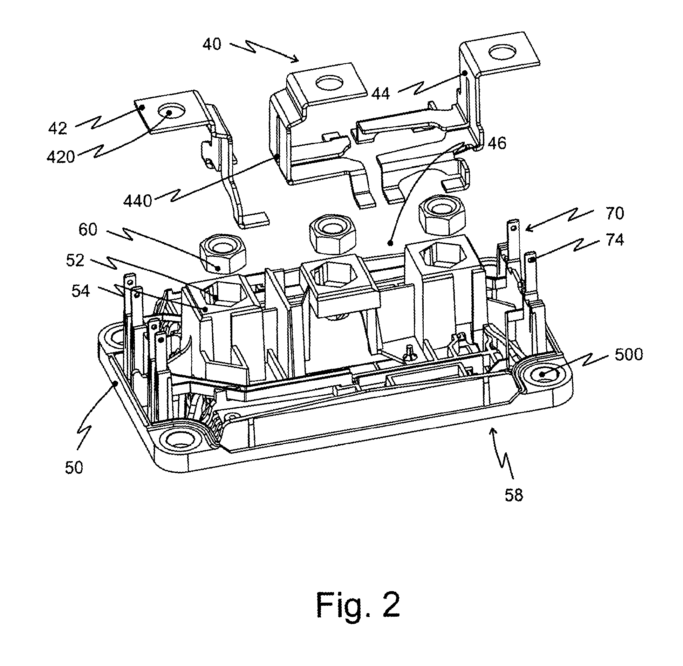

Fig. 2 zeigt in einer Explosionszeichnung schematisch zwei Herstellungsschritte im Rahmen des erfindungsgemäßen Herstellungsverfahrens eines erfindungsgemäßen Leistungshalbleitermoduls (1). Dargestellt sind die gleichen Komponenten wie in Fig. 1 ohne den Schaltungsträger und ohne das Gehäuse. Allerdings ist hier die Anordnung der Schraubenmutter (60) in den zweiten Aussparungen (52) des Kunststoffformkörpers (50) verdeutlicht. Diese zweiten Aussparungen (52) sind in Domen angeordnet, die jeweils eine Fläche (54) aufweisen, die als Widerlager für die ersten Kontakteinrichtungen (42) der Lastanschlusselemente (40) dient. Die Fläche dieser ersten Widerlager (54) weist eine Flächennormale auf, die vom Schaltungsträger (20) weg gerichtet ist.

Die im nächsten Herstellungsschritt nach der Anordnung der Schraubenmuttern (60) anzuordnenden Lastanschlusselemente (40) weisen einen bandartigen Abschnitt (44) auf, der zwischen dem ersten (42) und den zweiten Kontakteinrichtungen (46) verläuft und mehrfach gekröpft ist. Wesentlich ist, dass dieser bandartige Abschnitt (44) bis fast an die erste Kontakteinrichtung (42) hin geschlitzt (440) ist. Dieser Schlitz (440) dient gleichzeitig der Positionierung der Lastanschlusselemente (40) zu dem Kunststoffformkörper (50), der zwischen seinen Domen diese miteinander verbindende Stege (56) aufweist. Diese Positionierung ist zudem für die Ausbildung der stoffschlüssigen Verbindung vorteilhaft.

Die Hilfsanschlusselemente (70) sind hier ohne Beschränkung der Allgemeinheit bereits in ihrer endgültigen Lage dargestellt. Der Zeitpunkt der Anordnung der Hilfsanschlusselemente (70) vor oder nach der Anordnung der Schraubenmuttern (60) ist nicht erfindungswesentlich.

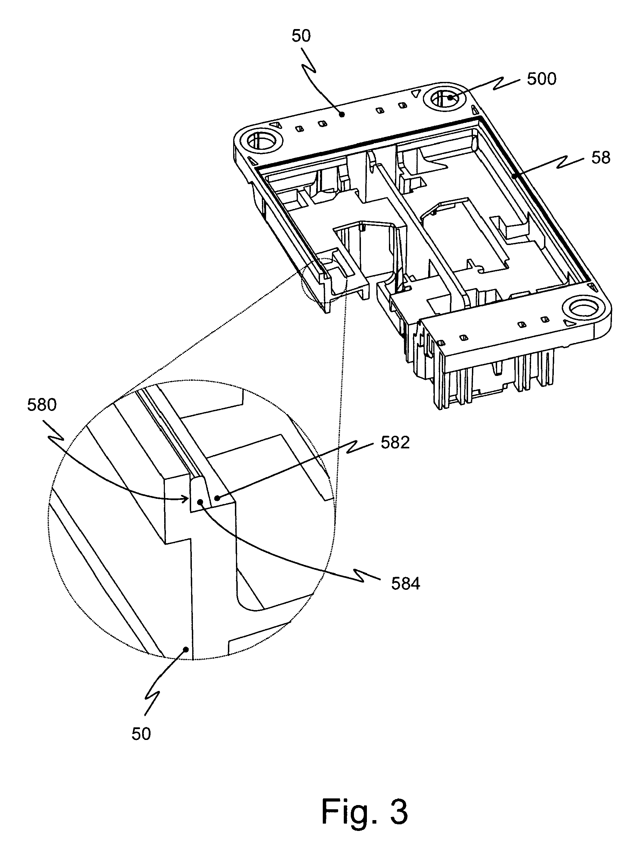

Fig. 3 zeigt einen Kunststoffformkörper (50) eines erfindungsgemäßen Leistungshalbleitermoduls (1). Dargestellt ist ein Schnitt durch die Unterseite des Kunststoffformkörpers (50), der eine Ausnehmung (58) zur Aufnahme eines Schaltungsträgers (20) zeigt. Diese Ausnehmung (58) weist einen Innenrand (580) und ein zweites Widerlager (582) auf.

Dieses zweite Widerlager (582) ist eine umlaufende Fläche, deren Flächennormale entgegengesetzt derjenigen der ersten Widerlager (52) gerichtet ist, wodurch die Lastanschlusselemente (40) und der damit verbundene Schaltungsträger (20) eine Art Klammer bilden um den Kunststoffformkörper (50) zu fixieren.

Weiterhin weist der Innenrand (580) eine dauerelastische Dichteinrichtung (584) auf, die sich von der Fläche des zweiten Widerlagers (584) nach außen hin verjüngt. Der Schaltungsträger (20) weist vorzugsweise eine jeweilige laterale Längenausdehnung auf, die größer ist als die Länge der freien Strecke zwischen den Fußpunkten der dauerelastischen Dichteinrichtung (584) an der Fläche des zweiten Widerlagers (582). Selbstverständlich ist die jeweilige laterale Längenausdehnung kleiner als die jeweilige Längenausdehnung der Ausnehmung (58) ohne dauerelastische Dichteinrichtung (584).

Zur Anordnung des Schaltungsträgers (20) in der Ausnehmung (58) mit angeordneter, vorzugsweise in einem Zweikomponentenspritzverfahren mit dem Kunststoffformkörper (50) hergestellter dauerelastischer Dichteinrichtung (584), wird dieser in die Ausnehmung (58) gepresst, wodurch die dauerelastische Dichteinrichtung (584) derart am Außenrand (22, vgl. Fig. 1) des Schaltungsträgers (20) anliegt, dass der Innenraum des Leistungshalbleitermoduls (1) nach unten hin dicht ausgebildet ist. Dies ist beispielhaft bei der Anordnung einer inneren Isolierung in Form eines Silikonkautschuks notwendig, da dieser vor der Vernetzung eine gelartige Konsistenz aufweist und durch einen möglichen Spalt austreten könnte.

## Patentansprüche

1. Leistungshalbleitermodul (1) zur Anordnung auf einem Kühlbauteil, mit einem Gehäuse (10), mindestens einem Schaltungsträger (20) mit einer hierauf ausgebildeten leistungselektronischen Schaltungsanordnung (30) und von dieser ausgehend mindestens einem Lastanschlusselement (40), das eine erste Kontakteinrichtung (42) mit einer ersten Aussparung (420) zur externen Verbindung, einen bandartigen Abschnitt (44) und mindestens zwei zweite Kontakteinrichtungen (46) elektrisch leitend mit der leistungselektronischen Schaltungsanordnung (30) verbunden aufweist, und mit einem von dem Gehäuse (10) teilweise umschlossenen Kunststoffformkörper (50),
der an seiner dem Schaltungsträger (20) abgewandten Seite mindestens eine Fläche (54) mit einer zweiten Aussparung (52) und mit einer hierin angeordneten Verbindungseinrichtung (60) aufweist,
wobei die erste Kontakteinrichtung (42) des mindestens einen Lastanschlusselements (40) diese zweite Aussparung (52) überdeckt und auf der ein erstes Widerlager (54) bildenden Fläche des Kunststoffformkörpers (50) aufliegt.

2. Leistungshalbleitermodul nach Anspruch 1,
wobei der jeweilige Schaltungsträger (20) in einer zugeordneten Ausnehmung (58) mit einem zweiten Widerlager (582) des Kunststoffformkörpers (50) angeordnet und somit von diesem seitlich umschlossen und in Richtung des Innenraums des Leistungshalbleitermoduls (1) fixiert ist.

3. Leistungshalbleitermodul nach Anspruch 2,
wobei zwischen dem Innenrand (580) der Ausnehmung (58) und dem Schaltungsträger (32) eine dauerelastische Dichteinrichtung (584) angeordnet ist.

4. Leistungshalbleitermodul nach Anspruch 1,
die zweiten Kontakteinrichtungen (46) des Lastanschlusselements (40) stoffschlüssig jeweils mit Kontaktpartnern, einer Leiterbahn (34) oder einem Leistungshalbleiterbauelement, der leistungselektronischen Schaltungsanordnung (30) verbunden sind.

5. Leistungshalbleitermodul nach Anspruch 1,
wobei der bandartige Abschnitt (44) ist zu mehr als 80% des Verlaufs von den zweiten Kontakteinrichtung (46) her geschlitzt (440) ausgebildet ist.

6. Verfahren zur Herstellung eines Leistungshalbleitermoduls (1) ausgebildet gemäß einem der vorhergehenden Ansprüche, **gekennzeichnet durch** folgende wesentliche Schritte:
• Bereitstellen mindestens eines Schaltungsträgers (20) mit einer hierauf ausgebildeten leistungselektronischen Schaltungsanordnung (30);
• Anordnen des jeweiligen Schaltungsträgers (20) in der zugeordneten Ausnehmung (58) des Kunststoffformteils (50);
• Anordnen der Verbindungseinrichtung (60) in der zweiten Ausnehmung (52) des Kunststoffformkörpers (50);
• Anordnen des mindestens einen Lastanschlusselements (40) zu dem Kunststoffformkörper (50), wobei die erste Kontakteinrichtung (42) auf ihrem ersten Widerlager (54) zu liegen kommt und wobei die zweiten Kontakteinrichtungen (46) auf ihren Kontaktpartnern (34) der leistungselektronischen Schaltungsanordnung (30) zu liegen kommen;
• Ausbilden der schaltungsgerechten stoffschlüssigen Verbindung der zweiten Kontakteinrichtungen (46) mit den Kontaktpartnern (34) der leistungselektronischen Schaltungsanordnung (30);
• Anordnen des Gehäuses (10)

7. Verfahren nach Anspruch 6,
wobei gleichzeitig mit den Lastanschlusselementen (40) auch Hilfsanschlusselemente (70) mit weiteren Kontakteinrichtungen (72, 74) angeordnet werden und diese auch gleichzeitig mit den Lastanschlusselementen (40) schaltungsgerecht verbunden werden.

8. Verfahren nach Anspruch 6,
wobei die Ausnehmung (58) an ihrem dem Schaltungsträger (20) zugewandten Innenrand (580) eine dauerelastische Dichteinrichtung (584) aufweist und der Schaltungsträger (20) in die Ausnehmung (58) gepresst wird, wodurch die dauerelastische Dichteinrichtung (584) an dessen Außenrand (22) anliegt und den Innenraum des Leistungshalbleitermoduls nach unten abdichtet.

9. Verfahren nach Anspruch 6,
wobei die stoffschlüssige Verbindung eine Schweißverbindung ist.
